(19) Europäisches Patentamt / European Patent Office / Office européen des brevets

(11) **EP 2 095 391 B1**

(12) **EUROPÄISCHE PATENTSCHRIFT**

(45) Veröffentlichungstag und Bekanntmachung des Hinweises auf die Patenterteilung:
**09.11.2011 Patentblatt 2011/45**

(21) Anmeldenummer: **07846793.3**

(22) Anmeldetag: **23.11.2007**

(51) Int Cl.:
**H01J 37/09** (2006.01)    **H01J 37/305** (2006.01)
**H01J 37/145** (2006.01)

(86) Internationale Anmeldenummer:
**PCT/EP2007/010193**

(87) Internationale Veröffentlichungsnummer:
**WO 2008/071303 (19.06.2008 Gazette 2008/25)**

(54) **TEILCHENOPTISCHE ANORDNUNG**

PARTICLE-OPTICAL ARRANGEMENT

INSTALLATION OPTIQUE À PARTICULES

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **14.12.2006 DE 102006059162**

(43) Veröffentlichungstag der Anmeldung:
**02.09.2009 Patentblatt 2009/36**

(73) Patentinhaber: **Carl Zeiss NTS GmbH**
**73447 Oberkochen (DE)**

(72) Erfinder: **PREIKSZAS, Dirk**
**73447 Oberkochen (DE)**

(74) Vertreter: **Diehl & Partner GbR**
**Patentanwälte**
**Augustenstrasse 46**
**80333 München (DE)**

(56) Entgegenhaltungen:
**EP-A- 1 385 193      EP-A- 1 557 867**
**US-A- 5 023 453      US-A1- 2006 076 489**
**US-B1- 6 452 173      US-B1- 6 509 564**

**Beschreibung**

Die Erfindung betrifft eine teilchenoptische Anordnung, welche ein Elektronenmikroskopiesystem und ein Ionenstrahlbearbeitungssystem umfaßt.

Bei der Herstellung miniaturisierter Bauelemente besteht ein Bedarf danach, eine Probe mit einem Ionenstrahl zu bearbeiten und einen Fortgang dieser Bearbeitung im wesentlichen gleichzeitig mit der Bearbeitung mit Hilfe eines Elektronenmikroskops zu beobachten.

Hierzu kann eine Vorrichtung zum Einsatz kommen, welche eine kombinierte Anordnung aus einem Elektronenmikroskopiesystem zur Emission eines auf ein zu untersuchendes Objekt gerichteten Primärelektronenstrahls entlang einer Hauptachse des Elektronenmikroskopiesystems und ein Ionenstrahlbearbeitungssystem zur Emission eines auf das zu untersuchende Objekt gerichteten Ionenstrahls entlang einer Hauptachse des Ionenstrahlbearbeitungssystems umfaßt, wobei die Hauptachse des Elektronenmikroskopiesystems und die Hauptachse des Ionenstrahlbearbeitungssystems unter einem Winkel zueinander orientiert sind, so daß beide Strahlen auf einen gemeinsamen Bereich eines zu untersuchenden bzw. zu bearbeitenden Objekts gerichtet sein können. Derartige Systeme sind beispielsweise aus US 2005/0184251 A1 und aus US 6,855,938 bekannt.

Ein solches System kann beispielsweise dazu eingesetzt werden, um Informationen über eine Struktur von in einem Halbleiterwafer gefertigten Bauelementen zu erhalten. Beispielsweise kann mit dem Ionenstrahl ein senkrecht zu einer Oberfläche des Wafers orientierter Graben in den Wafer geschnitten werden, und mit dem Elektronenmikroskop kann sowohl der Fortgang der Bearbeitung mit dem Ionenstrahl verfolgt werden als auch ein elektronenmikroskopisches Bild einer Seitenfläche des Grabens gewonnen werden, um so ein Schnittbild einer gefertigten Halbleiterstruktur zu erzeugen. Während eines solchen Prozesses ist die Oberfläche des Wafers im wesentlichen orthogonal zur Richtung des Ionenstrahls orientiert, während der Elektronenstrahl schräg zur Oberfläche des Wafers orientiert ist.

Ein hochauflösendes Elektronenmikroskopiesystem umfaßt üblicherweise eine Objektivlinse, welche zu der Fokussierung des Elektronenstrahls sowohl eine Magnetlinse als auch eine elektrostatische Linse umfaßt. Hierbei erstrecken sich elektrische Felder der elektrostatischen Linse bis hin zur zu untersuchenden Probe. Wird dann beispielsweise ein Halbleiterwafer mit schräg zu einer Hauptachse des Elektronenmikroskopiesystems orientierter Oberfläche untersucht, führt die schräge Anordnung des Wafers zu einer Beeinflussung des elektrischen Feldes derart, daß dieses selbst bei rotationssymmetrischer Bauweise der elektrostatischen Linse nicht rotationssymmetrisch ist und die Fokussierung und Strahlführung des Elektronenstrahls negativ beeinflußt wird.

Ferner beeinflußt das aus der Objektivlinse des Elektronenmikroskopiesystems austretende elektrische Feld auch die Strahlführung des Ionenstrahls, so daß dieser von seinem gewünschten Verlauf abgelenkt wird und nicht an einem vorgesehen Ort auf die Probe trifft.

Es ist eine Aufgabe der vorliegenden Erfindung, eine teilchenoptische Anordnung aus einem Elektronenmikroskopiesystem und einem Ionenstrahlbearbeitungssystem vorzuschlagen, bei dem sowohl eine gute Fokussierung und Strahlführung des Elektronenstrahls als auch eine präzise Bearbeitung mit dem Ionenstrahl ermöglicht ist.

Zur Lösung dieser Aufgabe wird eine teilchenoptische Anordnung vorgeschlagen, welche umfaßt: ein Elektronenmikroskopiesystem zur Emission eines auf ein zu untersuchendes Objekt gerichteten Primärelektronenstrahls entlang einer Hauptachse des Elektronenmikroskopiesystems, und ein Ionenstrahlbearbeitungssystem zur Emission eines auf das zu untersuchende Objekt gerichteten Ionenstrahls entlang einer Hauptachse des Ionenstrahlbearbeitungssystems, wobei die Hauptachse des Elektronenmikroskopiesystems und die Hauptachse des Ionenstrahlbearbeitungssystems unter einem Winkel zueinander orientiert sind, wobei das Elektronenmikroskopiesystem eine Objektivlinse aufweist, welche tür eine Fokussierung des Elektronenstrahls eine Magnetlinse und eine elektrostatische Linse umfaßt und welche eine von der Hauptachse des Elektronenmikroskopiesystems durchsetzte Ringelektrode umfaßt, welche die einer Position des zu untersuchenden Objekts am nächsten angeordnete Komponente des Elektronenmikroskopiesystems ist, gekennzeichnet durch eine Abschirmelektrode, welche zwischen der Ringelektrode und der Hauptachse des Ionenstrahlbearbeitungssystems angeordnet ist.

Bei einer derartigen teilchenoptischen Anordnung ist es möglich, der Ringelektrode des Elektronenmikroskopiesystems eine Spannung zuzuführen, welche das aus der elektrostatischen Linse austretende Feld bei relativ zu der Hauptachse des Elektronenmikroskopiesystems gekippter Probe so beeinflußt, daß dieses elektrostatische Feld seine rotationssymmetrische Konfiguration zur Fokussierung und Strahlführung des Elektronenstrahls weitgehend behält, während die Abschirmelektrode eine Beeinflussung des Ionenstrahls durch das Feld der Ringelektrode weitgehend vermeidet. Somit ist es möglich, eine im Vergleich zur herkömmlichen Anordnung verbesserte Fokussierung und Strahlführung des Elektronenstrahls bei gleichzeitig geringer Beeinflussung des Ionenstrahls zu erreichen.

Die Abschirmelektrode kann hierbei in dem Sinne zwischen der Ringelektrode und der Hauptachse des Ionenstrahlbearbeitungssystems liegen, daß wenigstens eine zu der Hauptachse des Ionenstrahlbearbeitungssystems orthogonale mathematische Linie sowohl die Abschirmelektrode als auch die Ringelektrode schneidet.

Gemäß einer Ausführungsform der Erfindung ist die Abschirmelektrode mit einem dem zu untersuchenden Objekt nahen Teil eines Gehäuses des Ionenstrahlbearbeitungssystems elektrisch leitend verbunden. Somit kann die Abschirmelektrode beispielsweise zusammen mit dem Gehäuse des Ionenstrahlbearbeitungssystems auf Massepotential liegen.

Die Abschirmelektrode kann die Gestalt einer Platte haben, welche zwischen der Ringelektrode und der Hauptachse des Ionenstrahlbearbeitungssystems angeordnet ist. Insbesondere kann hierbei die Abschirmelektrode eine der Hauptachse des Ionenstrahlbearbeitungssystems zugewandte Oberfläche aufweisen, welche konkav gekrümmt ist. Gemäß einer Ausführungsform hierbei kann die Abschirmelektrode derart gekrümmt sein, daß sie die Hauptachse des Ionenstrahlbearbeitungssystems teilweise oder vollständig umgreift. Insbesondere kann die Abschirmelektrode als eine von der Hauptachse des Ionenstrahls durchsetzte Hülse ausgebildet sein, welche sich insbesondere in Richtung hin zu der Position des zu untersuchenden Objekts konisch verjüngen kann.

Gemäß einer Ausführungsform der vorliegenden Erfindung ist vorgesehen, daß die Abschirmelektrode eine um den Ionenstrahl gekrümmte Gestalt aufweist, wobei eine der Position des zu untersuchenden Objekts zugewandte Stirnfläche der Abschirmelektrode sich schräg zu einer zu der Hauptachse des Ionenstrahlbearbeitungssystem orthogonalen mathematischen Ebene erstreckt. Insbesondere kann hierbei vorgesehen sein, daß sich die Stirnfläche der Abschirmelektrode im wesentlichen parallel zu einer zu der Hauptachse des Elektronenmikroskopiesystems sich orthogonal erstreckenden Ebene erstreckt.

Gemäß einer Ausführungsform der Erfindung kann auch die Ringelektrode der Objektivlinse des Elektronenmikroskopiesystems eine sich hin zu der Position des zu untersuchenden Objekts konisch verjüngende Gestalt aufweisen.

Gemäß einer Ausführungsform der Erfindung umfaßt die teilchenoptische Anordnung eine Spannungsversorgungsvorrichtung, welche dazu ausgebildet ist, der Ringelektrode eine elektrische Spannung zuzuführen. Insbesondere kann die der Ringelektrode zugeführte elektrische Spannung dazu dienen, ein aus der Objektivlinse austretendes elektrisches Feld derart zu beeinflussen, daß dieses durch eine nicht orthogonal zur Hauptachse des Elektronenmikroskopiesystems angeordnete Ebene möglichst wenig deformiert wird und eine einer weitgehend rotationssymmetrischen Gestalt angenäherte Konfiguration desselben erhalten wird. Somit kann es vorteilhaft sein, die der Ringelektrode zugeführte elektrische Spannung in Abhängigkeit von der Orientierung des zu untersuchenden Objekts bezüglich der Hauptachse des Elektronenmikroskopiesystems einzustellen.

Somit ist es möglich, für einen gegebenen Arbeitsabstand des zu untersuchenden Objekts von dem der Position des Objekts zugewandten Ende des Objektivs und für eine gewünschte Orientierung des Objekts bezüglich der Hauptachse des Elektronenmikroskopiesystems die der Ringelektrode zugeführte elektrische Spannung so anzusteuern, daß das aus der Objektivlinse austretende elektrische Feld eine weitgehend rotationssymmetrische Konfiguration aufweist und entsprechend sich eine unter diesen Umständen zufriedenstellende Fokussierung und Strahlführung des Elektronenstrahls erzielen läßt.

In einigen Anwendungen in der Praxis ist es gewünscht, daß das zu untersuchende Objekt im wesentlichen orthogonal zur Hauptachse des Ionenstrahlbearbeitungssystems angeordnet ist. Auch für diese Anordnung läßt sich somit eine vorteilhafte Einstellung für die der Ringelektrode zugeführte Spannung finden.

Ist die gewünschte Orientierung des zu untersuchenden Objekts bezüglich der Hauptachse des Elektronenmikroskopiesystems festgelegt und die dieser Orientierung entsprechende vorteilhafte Spannung zur Zuführung an die Ringelektrode bestimmt, so kann gemäß einer Ausführungsform der Erfindung die Abschirmelektrode eine bestimmte Geometrie aufweisen, welche nachfolgend erläutert wird. Durch die Geometrie der Abschirmelektrode wird die Verteilung des aus der Objektivlinse austretenden Feldes wesentlich beeinflußt. Gemäß der beschriebenen Ausführungsform wird die Geometrie der Abschirmelektrode dann so eingestellt, daß für das elektrische Feld entlang der Hauptachse des Ionenstrahlbearbeitungssystems folgende Relation erfüllt ist:

$$\left| \frac{e}{2W_{kin}} \int_0^z E_{\perp}(z) \cdot z \cdot dz \right| < 10 \, \mu m$$

Bei diesem Integral erstreckt sich der Integrationsweg auf der Hauptachse des Ionenstrahlbearbeitungssystems ausgehend von dem Ort des zu untersuchenden Objekts bis ins Innere einer Ionenoptik des Ionenstrahlbearbeitungssystems. Die Integration erfolgt über die senkrecht zur Hauptachse des Ionenstrahlsbearbeitungssystems orientierte Komponente des elektrischen Feldes, und zwar multipliziert mit der Elementarladung e und gewichtet mit dem Abstand von der Position des zu untersuchenden Objekts. Wird die durch die Integration sich ergebende Größe durch zweimal die kinetische Energie der Ionen am Ort des zu untersuchenden Objekts geteilt, so soll sich ein Wert von kleiner 10 $\mu$m, insbesondere kleiner 5 $\mu$m ergeben.

Ist die Geometrie der Abschirmelektrode so ausgebildet, daß die obige Relation erfüllt ist, so ergibt sich eine vorteilhaft geringe Beeinflussung des Ionenstrahls durch das aus der Objektivlinse des Elektronenmikroskopiesystems austretenden elektrischen Feldes.

Ausführungsformen der vorliegenden Erfindung werden nachfolgend anhand von Figuren näher erläutert. Hierbei zeigt

Figur 1     eine herkömmliche teilchenoptische Anordnung, welche aus einem Elektronenmikroskopiesystem und einem Ionenstrahlbearbeitungssystem zusammengesetzt ist,

Figur 2a    einen Verlauf elektrischer und magnetischer Felder in einer Objektivlinse sowie Verläufe von Elektronen- und Ionenstrahlen in einer herkömmlichen teilchenoptischen Anordnung,

Figur 2b    eine Detaildarstellung der Figur 2a,

Figur 3a    einen Verlauf elektrischer und magnetischer Felder in einer Objektivlinse sowie Verläufe von Elektronen- und Ionenstrahlen in der teilchenoptischen Anordnung gemäß Figur 2a, jedoch mit geänderter Spannungsversorgung,

Figur 3b    eine Detaildarstellung der Figur 3a,

Figur 4     eine Detailansicht einer teilchenoptischen Anordnung gemäß einer Ausführungsform der Erfindung,

Figur 5a    einen Verlauf elektrischer und magnetischer Felder in einer Objektivlinse sowie Verläufe von Elektronen- und Ionenstrahlen in einer teilchenoptischen Anordnung gemäß einer Ausführungsform der Erfindung,

Figur 5b    eine Detaildarstellung der Figur 5a,

Figur 6a    einen Verlauf elektrischer und magnetischer Felder in einer Objektivlinse sowie Verläufe von Elektronen- und Ionenstrahlen in der teilchenoptischen Anordnung gemäß Figur 5a, jedoch mit geänderter Spannungsversorgung, und

Figur 6b    eine Detaildarstellung der Figur 6a.

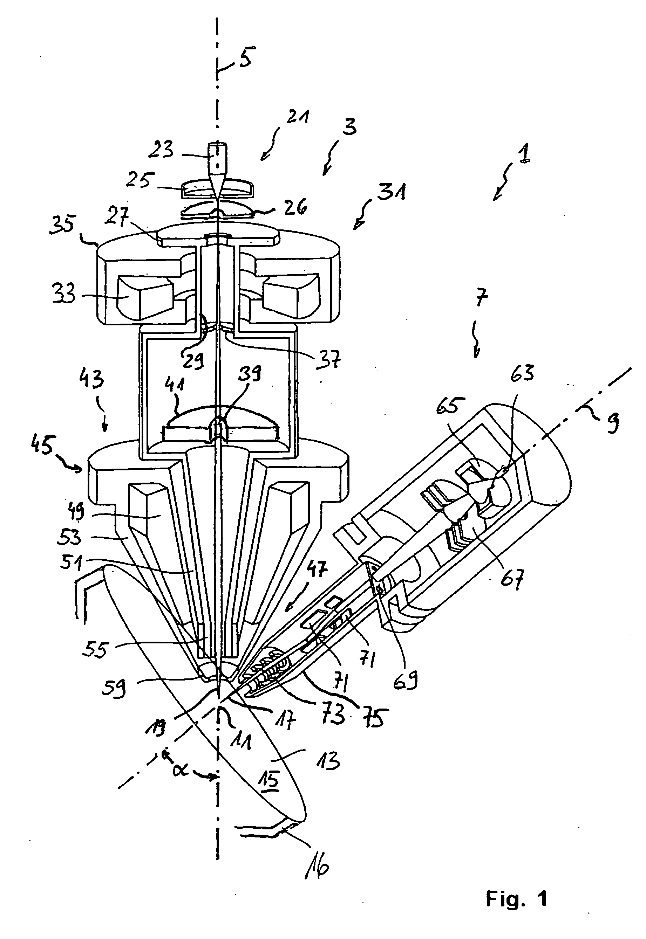

Figur 1 zeigt in perspektivischer und schematisch vereinfachter Darstellung eine teilchenoptische Anordnung 1 gemäß dem Stand der Technik und zur Erläuterung von Ausführungsformen der vorliegenden Erfindung. Die teilchenoptische Anordnung umfaßt ein Elektronenmikroskopiesystem 3 mit einer Hauptachse 5 und ein Ionenstrahlbearbeitungssystem 7 mit einer Hauptachse 9. Die Hauptachsen 5 und 9 des Elektronenmikroskopiesystems 3 bzw. des Ionenstrahlbearbeitungssystems 7 schneiden sich an einem Ort 11 unter einem Winkel α, welcher Werte von beispielsweise 45° bis 55° aufweisen kann, so daß ein zu untersuchendes Objekt 13, wie beispielsweise ein Halbleiterwafer, mit einer Oberfläche 15 in einem Bereich des Ortes 11 sowohl mit einem entlang der Hauptachse 9 des Ionenstrahlbearbeitungssystems 7 emittierten Ionenstrahl 17 bearbeitet als auch mit einem entlang der Hauptachse 5 des Elektronenmikroskopiesystems 3 emittierten Elektronenstrahl 19 untersucht werden kann. Zur Halterung des Objekts ist eine schematisch angedeutete Halterung 16, vorgesehen, welche das Objekt 13 im Hinblick auf Abstand von und Orientierung zu dem Elektronenmikroskopiesystem einstellen kann.

Hierzu umfaßt das Elektronenmikroskopiesystem 3 zur Erzeugung des Primärelektronenstrahls 19 eine Elektronenquelle 21, welche schematisch durch eine Kathode 23 und eine Anode 27 sowie einer hierzwischen angeordneten Suppressorelektrode 25 und einer mit Abstand hiervon angeordneten Extraktorelektrode 26 dargestellt ist. Weiter umfaßt das Elektronenmikroskopiesystem 3 eine Be-schleunigungselektrode 27, welche in ein Strahlrohr 29 übergeht und eine Kollimatoranordnung 31 durchsetzt, welche schematisch durch eine Ringspule 33 und ein Joch 35 dargestellt ist. Nach dem Durchlaufen der Kollimatoranordnung 31 durchsetzt der Primärelektronenstrahl eine Lochblende 37 und ein zentrales Loch 39 in einem Sekundärelektronendetektor 41, woraufhin der Primärelektronenstrahl 19 in eine Objektivlinse 43 des Elektronenmikroskopiesystems 3 eintritt. Die Objektivlinse 43 umfaßt zur Fokussierung des Primärelektronenstrahls 19 eine Magnetlinse 45 und eine elektrostatische Linse 47. Die Magnetlinse 45 umfaßt in der schematischen Darstellung der Figur 1 eine Ringspule 49, einen inneren Polschuh 51 und einen äußeren Polschuh 53. Die elektrostatische Linse 47 ist durch ein unteres Ende 55 des Strahlrohrs 29, das innere untere Ende des äußeren Polschuhs 53 sowie eine konisch sich hin zur Position 11 an der Probe sich verjüngende Ringelektrode 59 gebildet. Die Objektivlinse 43, welche in Figur 1 schematisch dargestellt ist, kann einen Aufbau aufweisen, wie er in US 6,855,938 detaillierter dargestellt ist.

Das Ionenstrahlbearbeitungssystem 7 umfaßt eine Ionenquelle 63 mit Extraktionselektrode 65, einen Kollimator 67, eine variable Blende 69, Ablenkelektroden 71 und Fokussierlinsen 73 zur Erzeugung des aus einem Gehäuse 75 des Ionenstrahlbearbeitungssystems 7 austretenden Ionenstrahls 17.

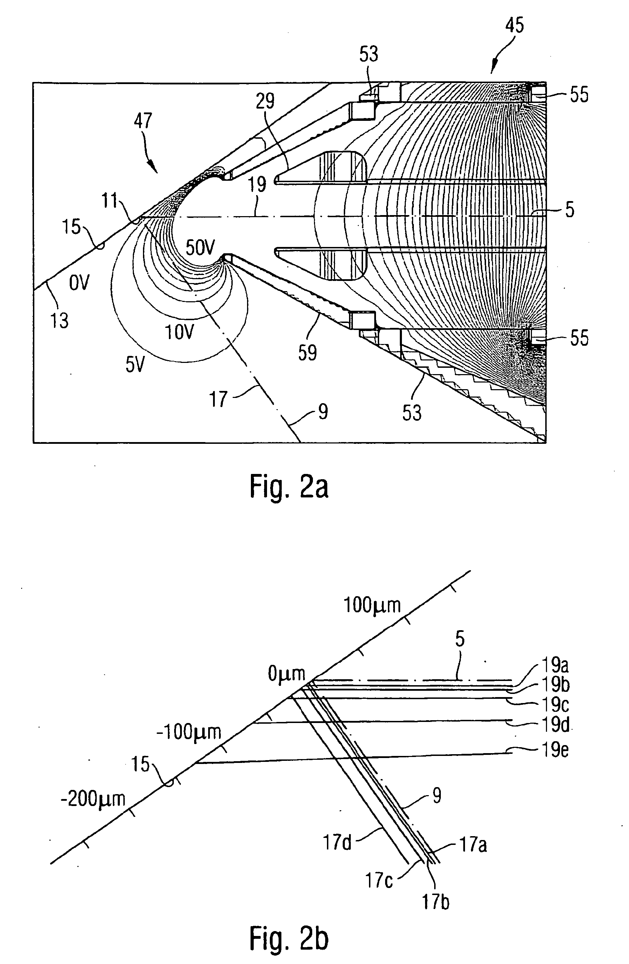

Figur 2a zeigt Details der elektrischen Linse 47 und der magnetischen Linse 45 der Objektivlinse 43 durch Darstellung von magnetischen und elektrischen Potentiallinien in einem Bereich der Objektivlinse 43 nahe dem Ort 11, an welchem sich die Hauptachse 5 des Elektronenmikroskopiesystems 3 und die Hauptachse 9 des Ionenstrahlbearbeitungssystems 7 schneiden. Figur 2a zeigt ein unteres Ende des inneren Polschuhs 55 sowie ein unteres inneres Ende des äußeren Polschuhs 53, welche so angeordnet sind, daß zwischen dem inneren Polschuh 55 und dem äußeren Polschuh 53 ein Polschuhspalt gebildet ist. Dieser Polschuhspalt ist von magnetischen Potentiallinien durchsetzt, welche sich hin zur Hauptachse 5 des Elektronenmikroskopiesystems aufweiten, um eine magnetische Linse für den Elektronenstrahl 19 zu bilden.

Die elektrische Linse 47 wird durch ein elektrisches Feld gebildet, welches durch eine Potentialdifferenz zwischen dem unteren Ende des Strahlrohrs 29 und der Ringelektrode 59 gebildet wird. In der in Figur 2a dargestellten Situation liegt die Ringelektrode 59 zusammen mit dem äußeren Polschuh 53 und der Probenoberfläche 15 auf Massepotential, während das Strahlrohr 29 auf einem Potential von zum Beispiel 8000 V liegt. Aufgrund der hohen Feldstärke zwischen dem unteren Ende des Strahlrohrs 29 und der Ringelektrode 59 sind die meisten Potentiallinien des elektrischen Feldes in Figur 2a der Übersichtlichkeit halber nicht dargestellt. In Figur 2a dargestellt sind lediglich die aus der Objektivlinse 43 austretenden Bereiche des elektrischen Feldes durch Potentiallinien für die Potentiale 50 V, 45 V, ..., 10 V und 5 V. Dem Verlauf der Potentiallinie für 50 V ist zu entnehmen, daß eine Rotationssymmetrie des aus der Objektivlinse 43 austretenden elektrischen Feldes aufgrund der Kippung der Oberfläche 15 der Probe, welche selbst auf einem Potential von 0 V liegt, bezüglich der Hauptachse 5 des Elektronenmikroskopiesystems stark gestört ist. Dies hat ungünstige Einflüsse auf die Fokussierung und die Strahlführung des Elektronenstrahls 19, insbesondere wenn dieser mit niedrigen Energien auf das Objekt 13 gerichtet ist. Dies ist in der weiter vergrößerten Darstellung um den Bereich 11 gemäß Figur 2b gezeigt. In Figur 2b stellen Linien 19a, 19b, 19c, 19d und 19e Hauptachsen des Elektronenstrahls 19 für die Energien 20 keV, 10 keV, 5 keV, 2 keV bzw. 1 keV dar. Mit geringer werdender kinetischer Energie des Elektronenstrahls trifft dieser somit mit immer größer werdendem Abstand von dem Schnittpunkt der Hauptachse 5 des Elektronenmikroskopiesystems mit der Oberfläche 15 auf diese Oberfläche 15 des Objekts 13. Dieser Abstand kann aus der in Figur 2b eingetragenen Längenskala abgelesen werden, auf der der Schnittpunkt zwischen der Hauptachse 5 und der Oberfläche 15 bei 0 $\mu$m angeordnet ist, der Schnittpunkt zwischen dem Elektronenstrahl 19d für die Energie 2 keV und der Oberfläche 15 bei etwa -65 $\mu$m angeordnet ist und der Schnittpunkt zwischen dem Elektronenstrahl 19e für die Energie 1 keV und der Oberfläche bei etwa -130 $\mu$m angeordnet ist.

Auch der Ort des Auftreffens des Ionenstrahls 17 auf die Oberfläche 15 hängt von der Energie des Ionenstrahls ab. Figur 2b zeigt Hauptachsen 17a, 17b, 17c und 17d des Ionenstrahls 17 für die Energien 30 keV, 20 keV, 10 keV bzw. 5 keV. Der Ionenstrahl 17d für die Energie 5 keV trifft bei einem Abstand von etwa - 25 $\mu$m von der Hauptachse 9 des Ionenstrahlbearbeitungssystems auf die Oberfläche 15 des Objekts.

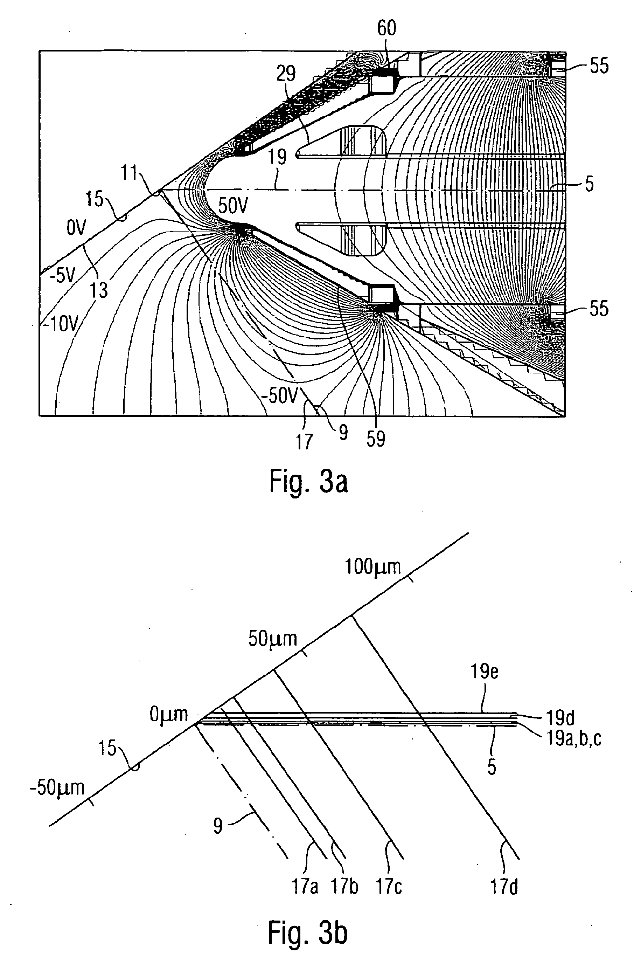

Figur 3a zeigt eine Maßnahme, um die Asymmetrie des aus der Objektivlinse 43 austretenden elektrischen Feldes zu verringern. Gemäß Figur 3a wird der Ringelektrode 59 von einer schematisch als Block 60 dargestellten Spannungsversorgung eine elektrische Spannung von -150 V zugeführt, was im Vergleich der Figuren 2a und 3a zu einer deutlichen Symmetrisierung der Verteilung des elektrischen Feldes nahe der Probe führt. Dies hat einen günstigen Effekt auf die Fokussierung und Strahlführung des Elektronenstrahls, wie aus der der Figur 2b entsprechenden Darstellung der Figur 3b ersichtlich ist. In der Figur 3b sind wiederum Elektronenstrahlen 19a bis 19e für die Energien 20 keV, 10 keV, 5 keV, 2 keV bzw. 1 keV eingetragen, wobei der Strahl 19e für die Energie 1 keV mit einem Abstand von weniger als 10 $\mu$m von der Hauptachse 5 des Elektronenmikroskopiesystems auf die Oberfläche 15 des Objekts 13 trifft.

Das Zuführen des negativen elektrischen Potentials an die Ringelektrode 59 hat somit einerseits den Vorteil der Verbesserung der Fokussierung des Elektronenstrahls 19, weist allerdings andererseits den Nachteil einer Verschlechterung der Bearbeitbärkeit des Objekts durch den Ionenstrahl auf, da der Auftreffort desselben auf die Oberfläche 15 des Objekts 13 nun sehr stark energieabhängig ist. In Figur 3b sind wiederum Hauptachsen 17a bis 17d für Ionenstrahlen mit den Energien 30 keV, 20 keV, 10 keV bzw. 5 keV dargestellt, wobei der Strahl 17d für die Energie 5 keV mit einem Abstand von +75 $\mu$m von der Hauptachse 9 auf die Oberfläche 15 trifft.

Gemäß einer Ausführungsform der Erfindung kann dieser Nachteil weitgehend behoben werden, indem eine geeignete Abschirmelektrode in einem Bereich nahe dem Objekt angeordnet wird, so daß diese Abschirmelektrode zwischen der Ringelektrode 59 und der Hauptachse 9 des Ionenstrahlbearbeitungssystems 7 angeordnet ist.

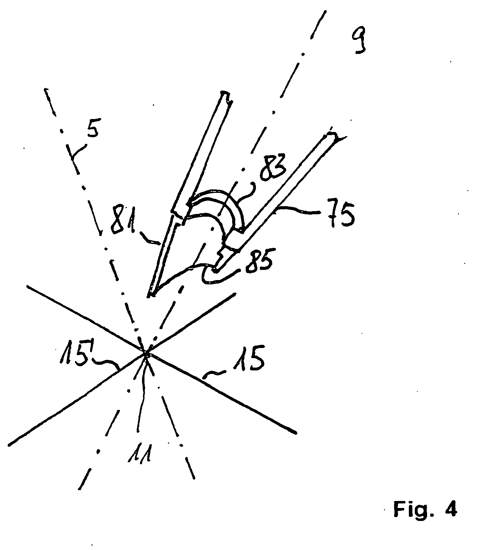

Figur 4 zeigt eine beispielhafte Ausführungsform einer derartigen Abschirmelektrode 81, welche als konisch sich entlang der Hauptachse 9 des Ionenstrahlbearbeitungssystems hin zu dem Objekt 15 verjüngende Hülse ausgebildet ist, welche an einen Flansch 83 des Gehäuses 75 des Ionenstrahlbearbeitungssystem 7 angebracht ist. Eine dem Objekt 15 zuweisende Stirnfläche 85 der konischen Abschirmelektrode 81 ist hierbei schräg zur Hauptachse 9 des Ionenstrahlbearbeitungssystems 7 orientiert.

Die mit dem Bezugszeichen 15 versehene Linie in Figur 4 stellt die Probenoberfläche in der Stellung dar, in welcher diese orthogonal zur Hauptachse 9 orientiert ist. Das Bezugszeichen 15' stellt die Oberfläche des Objekts in der Position dar, in welcher diese im wesentlichen orthogonal zur Hauptachse 5 des Elektronenmikroskopiesystems 3 angeordnet ist. In der in Figur 4 dargestellten Ausführungsform ist die Stirnfläche 85 der Abschirmelektrode 81 im wesentlichen parallel zu der Ebene 15' orientiert.

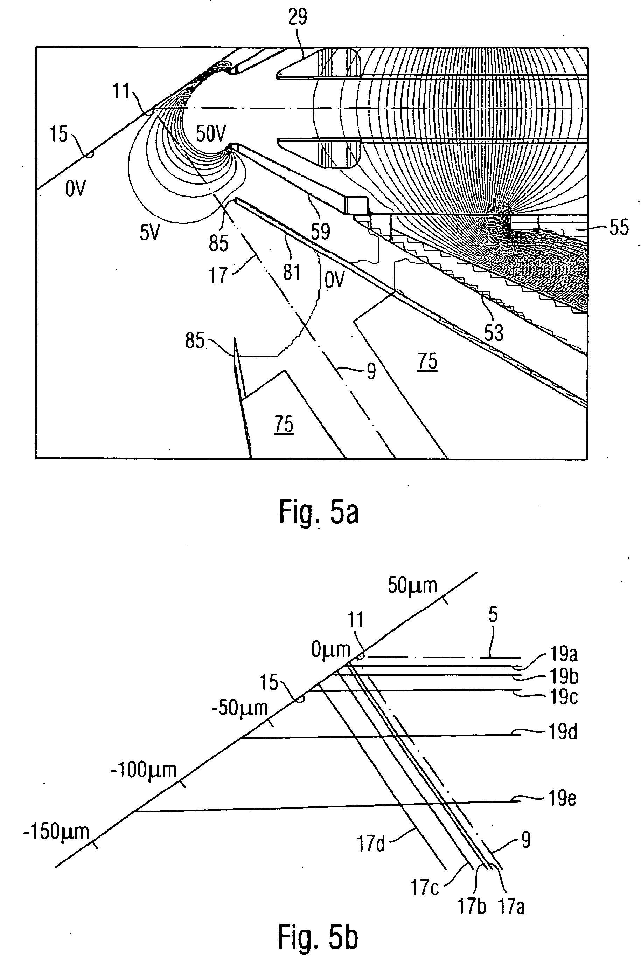

Figur 5a ist eine der Figur 2a entsprechende Darstellung, bei der der Ringelektrode 59 ein Potential von 0 V zugeführt ist und ein relativ geringer Einfluß der Abschirmelektrode 81 auf das elektrische Feld ersichtlich ist.

Figur 5b ist eine der Figur 2b entsprechende Darstellung, in welcher Linien 19a bis 19e Hauptachsen des Elektronenstrahls für die Energien 20 keV, 10 keV, 5 keV, 2 keV bzw. 1 keV darstellen und Linien 17a bis 17d Hauptachsen des Ionenstrahls für die Energien 30 keV, 20 keV, 10 keV bzw. 5 keV darstellen. Ähnlich wie in Figur 2b trifft der Elektronenstrahl 19e für die Energie 1 keV mit einem Abstand von -130 μm von der Hauptachse 5 des Elektronenmikroskopiesystems auf die Oberfläche 15 des Objekts. Ebenso trifft der Ionenstrahl 17b mit der Energie 5 keV mit einem Abstand von etwa -25 μm von der Hauptachsen 9 des Ionenstrahlbearbeitungssystems auf die Oberfläche 15 des Objekts.

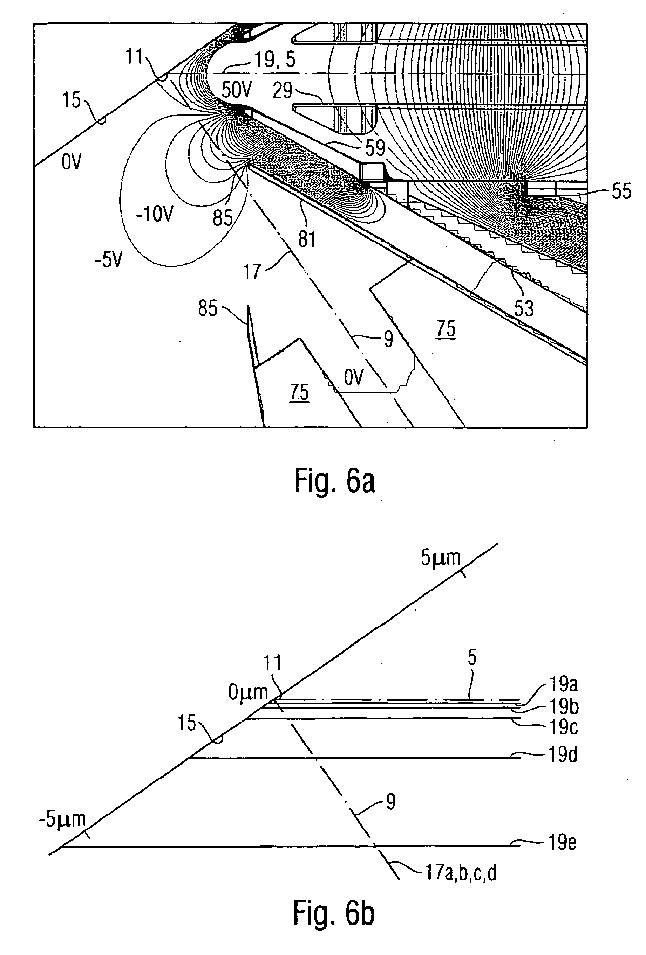

Figur 6a ist eine der Figur 3a entsprechende Darstellung, bei welcher der Ringelektrode 59 wiederum ein elektrisches Potential von -150 V zur Symmetrisierung des elektrischen Feldes für die Fokussierung und Strahlführung des Elektronenstrahls zugeführt ist. Aus der Figur 6a ist ein deutlicher Einfluß der Abschirmelektrode 81 auf die Verteilung des elektrischen Feldes ersichtlich. Dieser Einfluß der Abschirmelektrode 81 läßt eine gute Fokussierung und Strahlführung sowohl des Elektronenstrahls 19 als auch des Ionenstrahls 17 zu, wie aus der der Figur 3b entsprechenden Darstellung gemäß Figur 6b ersichtlich ist. In der Figur 6b repräsentieren die Linien 19a bis 19e wiederum Hauptachsen des Elektronenstrahls für die Energien 20 keV, 10 keV, 5 keV, 2 keV bzw. 1 keV. Der Elektronenstrahl 19e trifft mit einem Abstand von -5,7 μm von der Hauptachse 5 des Elektronenmikroskopiesystems auf die Oberfläche 15 des Objekts auf, was im Vergleich zur Figur 2b ein relativ gutes Ergebnis repräsentiert. Aufgrund der speziell gewählten Geometrie für die Abschirmelektrode 81, welche nachfolgend erläutert wird, fallen Hauptachsen 17a bis 17d des Ionenstrahls für die Energien 30 keV, 20 keV, 10 keV bzw. 5 keV in der Darstellung der Figur 6b praktisch zusammen und schneiden die Oberfläche 15 des Objekts 13 zusammen mit der Hauptachse 9 des Ionenstrahlbearbeitungssystems und zusammen mit der Hauptachse 5 des Elektronenmikroskopiesystems. Der Auftreffort des Ionenstrahls 17 ist somit im wesentlichen unabhängig von der Energie des Ionenstrahls. Dies ist im Vergleich mit den Figuren 2b und 3b ein sehr gutes Ergebnis.

Das Fehlen einer wesentlichen Energieabhängigkeit des Auftrefforts des Ionenstrahls auf die Oberfläche 15 des Objekts 13 ist auf die spezielle Wahl der Geometrie der Abschirmelektrode 81 zurückzuführen. Wie aus Figur 6a ersichtlich ist, durchsetzt der Ionenstrahl auf seinem Weg aus dem Gehäuse 75 der Ionenoptik heraus und hin zur Oberfläche 15 des Objekts 13 zuerst einen Bereich, in dem eine quer zur Achse 9 orientierte Komponente des elektrischen Feldes in der Darstellung der Figur 6a nach rechts gerichtet ist und sodann einen Bereich, in dem diese Komponente des elektrischen Feldes nach links gerichtet ist. Dies führt zu einer Ablenkung des Ionenstrahls zunächst nach rechts und dann, kurz vor dem Auftreffen auf die Oberfläche 15, nach links. Die Geometrie der Abschirmelektrode ist so bemessen, daß sich die Ablenkungen nach rechts und nach links zu Null kompensieren. Dies ist dann der Fall, wenn folgende Relation erfüllt ist:

$$\left| \frac{e}{2W_{kin}} \int_0^z E_\perp(z) \cdot z \cdot dz \right| < 10\,\mu m,$$

welche oben bereits erläutert wurde.

Eine teilchenoptische Anordnung gemäß einer Ausführungsform der vorliegenden Erfindung weist somit grundsätzlich einen Aufbau auf, wie er anhand der Figur 1 vorangehend erläutert wurde, wobei allerdings zusätzlich eine Abschirmelektrode zwischen der Ringelektrode der Objektivlinse des Elektronenmikroskopiesystems und der Hauptachse des Ionenstrahlbearbeitungssystems angeordnet ist. Die Abschirmelektrode kann beispielsweise einen Aufbau aufweisen, wie er anhand der Figur 4 erläutert wurde. Die Abschirmelektrode muß allerdings nicht als Hülse ausgebildet sein und die Hauptachse 9 des Ionenstrahlbearbeitungssystems umgreifen sondern kann auch eine hiervon abweichende Gestalt aufweisen. Beispielsweise kann die Abschirmelektrode auch als eine im wesentlichen ebene Platte ausgebildet sein, welche zwischen der Ringelektrode der Objektivlinse und der Hauptachse des Ionenstrahlbearbeitungssystems angeordnet ist.

Das Ionenstrahlbearbeitungssystem weist, wie in Figur 1 dargestellt, Strahlablenker 71 auf, um den Ionenstrahl aus der Hauptachse 9 des Ionenstrahlbearbeitungssystems 7 auszulenken, so daß der Ionenstrahl 17 an Orten auf die Oberfläche 15 des Objekts 13 auftreffen kann, welche von dem Schnittpunkt 11 der Hauptachse 9 des Ionenstrahlbearbeitungssystems 7 und der Ebene 15 verschieden sind. In den Figuren 2, 3, 5 und 6 sind mit den Bezugszeichen 17a bis 17d jedoch jeweils Ionenstrahlen bezeichnet, welche nicht durch Ansteuerung der Strahlablenker von der Hauptachse 9 versetzt sein sollen, sondern lediglich durch die Einwirkung des aus der Objektivlinse des Elektronenmikroskopiesystems austretenden Feldes von der Hauptachse 9 abgelenkt sind.

Ähnlich weist das Elektronenmikroskopiesystem Strahlablenker für den Elektronenstrahl auf, welche typischerweise in der Objektivlinse angeordnet und in Figur 1 nicht dargestellt sind. Mit diesen Strahlablenkern wird der Elektronenstrahl über die Oberfläche des zu untersuchenden Objekts gerastert, um eine rasterelektronenmikroskopische Aufnahme des Objekts zu gewinnen. In den Darstellungen der Figuren 2, 3, 5 und 6 bezeichnen die Bezugszeichen 19a bis 19e jedoch Elektronenstrahlen, welche nicht durch Ansteuerung von Strahlablenkern sondern lediglich aufgrund der Wirkung des aus der Objektivlinse austretenden elektrischen Feldes von der Hauptachse 5 des Elektronenmikroskopiesystems ausgelenkt sind.

In der vorangehend beschriebenen Ausführungsform ist die Abschirmelektrode 81 mit dem Gehäuse 75 des Ionenstrahlbearbeitungssystems leitend verbunden und liegt somit in den meisten Anwendungen auf Massepotential.

Es ist jedoch auch möglich, der Abschirmelektrode 81 durch eine hierfür vorgesehene Spannungsversorgung ein elektrisches Potential zuzuführen, welches von dem Massepotential verschieden ist. Es kann dann sinnvoll sein, die Abschirmelektrode von dem Gehäuse des Ionenstrahlbearbeitungssystems elektrisch zu isolieren. Durch die Zuführung einer solchen Spannung an die Abschirmelektrode kann das elektrische Feld vor dem zu untersuchenden Objekt beeinflußt und insbesondere weiter im Hinblick auf die Strahlführungen des Elektronenstrahls und des Ionenstrahls optimiert werden. Dies kann insbesondere dann ausgenutzt werden, wenn bei bestimmten Winkeln $\alpha$ es durch Wahl der Geometrie der Abschirmelektrode nicht möglich ist, die durch die oben angegebene Formel definierte Relation zu erfüllen. Insbesondere ist es durch Ändern der der Abschirmelektrode zugeführten Spannung möglich, die durch die oben angegebene Formel bestimmte Relation bei mehreren verschiedenen Orientierungen $\alpha$ des Objekts relativ zu den Strahlachsen zu erfüllen.

Zusammenfassend umfaßt eine teilchenoptische Anordnung aus einem Elektronenmikroskopiesystem und einem Ionenstrahlbearbeitungssystem eine Objektivlinse des Elektronenmikroskopiesystems, welche eine Ringelektrode aufweist, welche eine einer Position eines zu untersuchenden Objekts am nächsten angeordnete Komponente des Elektronenmikroskopiesystems ist. Zwischen der Ringelektrode und einer Hauptachse des Ionenstrahlbearbeitungssystems ist eine Abschirmelektrode angeordnet.

**Patentansprüche**

1.  Teilchenoptische Anordnung, umfassend:

    ein Elektronenmikroskopiesystem (3) zur Emission eines auf ein zu untersuchendes Objekt (13) gerichteten Primärelektronenstrahls (19) entlang einer Hauptachse (5) des Elektronenmikroskopiesystems (3), und
    ein Ionenstrahlbearbeitungssystem (7) zur Emission eines auf das zu untersuchende Objekt (13) gerichteten Ionenstrahls entlang einer Hauptachse (9) des Ionenstrahlbearbeitungssystems (7), wobei die Hauptachse (5) des Elektronenmikroskopiesystems (3) und die Hauptachse (9) des Ionenstrahlbearbeitungssystems (7) unter einem Winkel ($\alpha$) zueinander orientiert sind,
    wobei das Elektronenmikroskopiesystem (3) eine Objektivlinse (43) aufweist, welche für eine Fokussierung des Elektronenstrahls (19) eine Magnetlinse (45) und eine elektrostatische Linse (47) umfaßt und welche eine von der Hauptachse (5) des Elektronenmikroskopiesystems (3) durchsetzte Ringelektrode (59) umfaßt, welche die einer Position (11) des zu untersuchenden Objekts (13) am nächsten angeordnete Komponente des Elektronenmikroskopiesystems (3) ist,
**gekennzeichnet durch** eine Abschirmelektrode (81), welche zwischen der Ringelektrode (59) und der Hauptachse (9) des Ionenstrahlbearbeitungssystems (7) angeordnet ist.

2.  Teilchenoptische Anordnung nach Anspruch 1, wobei die Abschirmelektrode (81) derart angeordnet ist, daß wenigstens eine zu der Hauptachse (9) des Ionenstrahlbearbeitungssystems (7) orthogonale mathematische Linie sowohl die Abschirmelektrode (81) als auch die Ringelektrode (59) schneidet.

3.  Teilchenoptische Anordnung nach Anspruch 1 oder 2, wobei die Abschirmelektrode (81) mit einem der Position (11) des zu untersuchenden Objekts (13) am nächsten angeordneten Teil eines Gehäuses (75) des Ionenstrahlbearbeitungssystems (7) elektrisch leitend verbunden ist.

4.  Teilchenoptische Anordnung nach Anspruch 1 oder 2, ferner umfassend eine Spannungsversorgungsvorrichtung zum Zuführen einer elektrischen Spannung an die Abschirmelektrode (81).

5.  Teilchenoptische Anordnung nach einem der Ansprüche 1 bis 4, wobei eine der Hauptachse (9) des Ionenstrahlbearbeitungssystems (7) zugewandte Oberfläche der Abschirmelektrode (81) konkav gekrümmt ist.

6.  Teilchenoptische Anordnung nach Anspruch 5, wobei die Abschirmelektrode (81) als eine die Hauptachse (9) des Ionenstrahlbearbeitungssystems (7) wenigstens teilweise umgreifende Hülse ausgebildet ist.

7.  Teilchenoptische Anordnung nach Anspruch 6, wobei die Hülse (81) sich hin zu der Position (11) des zu untersuchenden Objekts (13) konisch verjüngt.

8.  Teilchenoptische Anordnung nach einem der Ansprüche 1 bis 7, wobei die Abschirmelektrode (81) eine der Position (11) des zu untersuchenden Objekts (13) zugewandte Stirnfläche (85) aufweist, welche sich schräg zu einer zu der Hauptachse (9) des Ionenstrahlbearbeitungssystems (7) orthogonalen mathematischen Ebene (15) erstreckt.

9.  Teilchenoptische Anordnung nach Anspruch 8, wobei sich die Stirnfläche (85) der Abschirmelektrode (81) im wesentlichen parallel zu einer zu der Hauptachse (5) des Elektronenmikroskopiesystems (3) orthogonalen mathematischen Ebene (15') erstreckt.

**10.** Teilchenoptische Anordnung nach einem der Ansprüche 1 bis 9, wobei die Ringelektrode (59) sich hin zu der Position (11) des zu untersuchenden Objekts (13) konisch verjüngt.

**11.** Teilchenoptische Anordnung nach einem der Ansprüche 1 bis 10, ferner umfassend eine Spannungsversorgungsvorrichtung (60) zum Zuführen einer elektrischen Spannung an die Ringelektrode (59).

**12.** Teilchenoptische Anordnung nach einem der Ansprüche 1 bis 11, ferner umfassend eine Objekthalterung (16), welche dazu ausgebildet ist, das zu untersuchende Objekt (13) mit wenigstens zwei verschiedenen Orientierungen einer Oberfläche (15) des Objekts bezüglich der Hauptachse (5) des Elektronenmikroskopiesystems (3) zu haltern.

**13.** Teilchenoptische Anordnung nach Anspruch 12, in Verbindung mit Anspruch 11, wobei die von der Spannungsversorgungsvorrichtung (60) der Ringelektrode (59) während eines Betriebs der teilchenoptischen Anordnung (1) zugeführte Spannung bei verschiedenen Orientierungen der Oberfläche (15) des Objekts (13) bezüglich der Hauptachse (5) des Elektronenmikroskopiesystems (3) verschiedene Werte aufweist.

**14.** Teilchenoptische Anordnung nach Anspruch 13, wobei die Abschirmelektrode (81) derart konfiguriert ist, daß bei einer Orientierung der Oberfläche (15) des Objekts (13) im wesentlichen orthogonal zu der Hauptachse (9) des Ionenstrahlbearbeitungssystems (7) und entsprechender Einstellung der der Ringelektrode (59) während des Betriebs zugeführten Spannung eine Verteilung eines elektrischen Feldes entlang der Hauptachse des Ionenstrahlbearbeitungssystems derart entsteht, daß folgende Relation erfüllt ist:

$$\left| \frac{e}{2W_{kin}} \int_0^z E_\perp(z) \cdot z \cdot dz \right| < 10\,\mu m \, ,$$

wobei

*e* die Elementarladung repräsentiert,
*z* den Abstand von der Oberfläche (15) des Objekts (13) entlang der Hauptachse (9) des Ionenstrahlbearbeitungssystems (7) repräsentiert,
$E_\perp(z)$ die senkrecht zur Hauptachse (9) des Ionenstrahlbearbeitungssystems (7) orientierte Komponente des elektrischen Feldes an einem entlang der Hauptachse (9) mit Abstand z von der Oberfläche (15) des Objekts (13) angeordnetem Ort repräsentiert,
*Z* einen Abstand entlang der Hauptachse (9) des Ionenstrahlbearbeitungssystems (7) zu einem innerhalb einer Ionenoptik des Ionenstrahlbearbeitungssystems angeordneten Ort repräsentiert, und
$W_{kin}$ eine kinetische Energie der Ionen des Ionenstrahls am Ort des Objekts repräsentiert.

## Claims

**1.** A particle optical arrangement, comprising:

an electron microscopy system (3) for emitting a primary electron beam (19) directed to an object (13) to be examined along a principal axis (5) of the electron microscopy system (3), and an ion beam processing system (7) for emitting an ion beam, directed to the object (13) to be examined, along a principal axis (9) of the ion beam processing system (7), wherein the principal axis (5) of the electron microscopy system (3) and the principal axis (9) of the ion beam processing system (7) are oriented relative to each other such that they enclose an angle ($\alpha$), wherein the electron microscopy system (3) comprises an objective lens (43) comprising, for focussing the electron beam (19), a magnetic lens (45) and an electrostatic lens (47) and comprising an annular electrode (59) which is traversed by the principal axis (5) of the electron microscopy system (3) and constitutes a component of the electron microscopy system (3) which is arranged closest to a position (11) of the object (13) to be examined, **characterized by** a shielding electrode (81) arranged between the annular electrode (59) and the principal axis (9) of the ion beam processing system (7).

**2.** The particle optical arrangement according to claim 1, wherein the shielding electrode (81) is arranged such that at least one mathematical line orthogonal to the principal axis (9) of the ion beam processing system (7) intersects with both the shielding electrode (81) and the annular electrode (59).

**3.** The particle optical arrangement according to claim 1 or 2, wherein the shielding electrode (81) is electroconductively connected to a portion of a housing (75) of the ion beam processing system (7) which portion is arranged closest to the position (11) of the object (13) to be examined.

**4.** The particle optical arrangement according to claim 1 or 2, further comprising a voltage supply for supplying an electric voltage to the shielding electrode (81).

5. The particle optical arrangement according to any one of claims 1 to 4, wherein a surface of the shielding electrode (81) facing the principal axis (9) of the ion beam processing system (7) is concavely shaped.

6. The particle optical arrangement according to claim 5, wherein the shielding electrode (81) is adapted as a sleeve (81) at least partially encompassing the principal axis (9) of the ion beam processing system (7).

7. The particle optical arrangement according to claim 6, wherein the sleeve (81) conically tapers towards the position (11) of the object (13) to be examined.

8. The particle optical arrangement according to any one of claims 1 to 7, wherein the shielding electrode (81) comprises a front face (85) facing the position (11) of the object (13) to be examined, which front face (85) extends transversely to a mathematical plane (15) orthogonal to the principal axis (9) of the ion beam processing system (7).

9. The particle optical arrangement according to claim 8, wherein the front face (85) of the shielding electrode (81) extends substantially parallel to a mathematical plane (15') orthogonal to the principal axis (5) of the electron microscopy system (3).

10. The particle optical arrangement according to any one of claims 1 to 9, wherein the annular electrode (59) conically tapers towards to the position (11) of the object (13) to be examined.

11. The particle optical arrangement according to any one of claims 1 to 10, further comprising a voltage supply (60) for supplying an electric voltage to the annular electrode (59).

12. The particle optical arrangement according to any one of claims 1 to 11, further comprising an object holder (16) adapted to hold the object (13) to be examined in at least two different orientations of a surface (15) of the object relative to the principal axis (5) of the electron microscopy system (3).

13. The particle optical arrangement according to claim 12, in combination with claim 11, wherein the voltage supplied from the voltage supply (60) to the annular electrode (59) during operation of the particle optical arrangement (1) has different values for different orientations of the surface (15) of the object (13) relative to the principal axis (5) of the electron microscopy system (3).

14. The particle optical arrangement according to claim 13, wherein the shielding electrode (81) is configured such that, when the surface (15) of the object (13) is oriented substantially orthogonal to the principal axis (9) of the ion beam processing system (7) and the voltage supplied to the annular electrode (59) during the operation is accordingly adjusted, a distribution of an electric field along the principal axis of the ion beam processing system is established such that the following relation is satisfied:

$$\left| \frac{e}{2W_{kin}} \int_0^z E_\perp(z) \cdot z \cdot dz \right| < 10\,\mu m,$$

wherein

$e$ represents the elementary charge,
$z$ represents the distance from the surface (15) of the object (13) along the principal axis (9) of the ion beam processing system (7),
$E_\perp(z)$ represents the component of the electric field perpendicular to the principal axis (9) of the ion beam processing system (7) at a location arranged at a distance z apart from the surface (15) of the object (13) along the principal axis (9),
$Z$ represents a distance along the principal axis (9) of the ion beam processing system (7) to a location arranged within an ion optics of the ion beam processing system (7), and
$W_{kin}$ represents a kinetic energy of the ions of the ion beam at the location of the object.

**Revendications**

1. Installation optique à particules, comprenant :

un système de microscopie électronique (3) pour émettre un faisceau d'électrons primaire (19) dirigé sur un objet (13) à examiner, suivant un axe principal (5) du système de microscopie électronique (3), et
un système de traitement à faisceau d'ions (7) pour émettre un faisceau d'ions dirigé sur l'objet (13) à examiner, suivant un axe principal (9) du système de traitement à faisceau d'ions (7),
l'axe principal (5) du système de microscopie électronique (3) et l'axe principal (9) du système de traitement à faisceau d'ions (7) étant orientés sous un angle ($\alpha$) l'un par rapport à l'autre,
dans laquelle le système de microscopie électronique (3) présente une lentille d'objectif (43) qui comprend une lentille magnétique (45) et une lentille électrostatique (47) pour une focalisation du faisceau d'électrons (19) et qui comprend une électrode annulaire (59) traversée par l'axe principal (5) du système de microscopie électronique (3) et qui est le composant du système de microscopie électronique (3) disposé le plus près d'une position (11) de l'objet (13) à examiner,

**caractérisée par** une électrode de protection (81) qui est disposée entre l'électrode annulaire (59) et l'axe principal (9) du système de traitement à faisceau d'ions (7).

2. Installation optique à particules selon la revendication 1, dans laquelle l'électrode de protection (81) est disposée de telle sorte qu'au moins une ligne mathématique orthogonale à l'axe principal (9) du système de traitement à faisceau d'ions (7) coupe aussi bien l'électrode de protection (81) que l'électrode annulaire (59).

3. Installation optique à particules selon la revendication 1 ou 2, dans laquelle l'électrode de protection (81) est reliée de façon électriquement conductrice à une partie d'un boîtier (75) du système de traitement à faisceau d'ions (7) disposée le plus près de la position (11) de l'objet (13) à examiner.

4. Installation optique à particules selon la revendication 1 ou 2, comprenant en outre un dispositif d'alimentation en tension pour amener une tension électrique à l'électrode de protection (81).

5. Installation optique à particules selon l'une quelconque des revendications 1 à 4, dans laquelle une surface de l'électrode de protection (81) du système de traitement à faisceau d'ions (7) tournée vers l'axe principal (9) est courbée de façon concave.

6. Installation optique à particules selon la revendication 5, dans laquelle l'électrode de protection (81) est réalisée comme une douille englobant au moins en partie l'axe principal (9) du système de traitement à faisceau d'ions (7).

7. Installation optique à particules selon la revendication 6, dans laquelle la douille (81) s'effile de façon conique vers la position (11) de l'objet (13) à examiner.

8. Installation optique à particules selon l'une quelconque des revendications 1 à 7, dans laquelle l'électrode de protection (81) présente une surface frontale (85) tournée vers la position (11) de l'objet (13) à examiner, ladite surface s'étendant de façon oblique à un plan mathématique (15) orthogonal à l'axe principal (9) du système de traitement à faisceau d'ions (7).

9. Installation optique à particules selon la revendication 8, dans laquelle la surface frontale (85) de l'électrode de protection (81) s'étend sensiblement en parallèle à un plan mathématique (15') orthogonal à l'axe principal (5) du système de microscopie électronique (3).

10. Installation optique à particules selon l'une quelconque des revendications 1 à 9, dans laquelle l'électrode annulaire (59) s'effile de façon conique vers la position (11) de l'objet (13) à examiner.

11. Installation optique à particules selon l'une quelconque des revendications 1 à 10, comprenant en outre un dispositif d'alimentation en tension (60) pour amener une tension électrique à l'électrode annulaire (59).

12. Installation optique à particules selon l'une quelconque des revendications 1 à 11, comprenant en outre un porte-objet (16) qui est réalisé pour porter l'objet (13) à examiner avec au moins deux orientations différentes d'une surface (15) de l'objet par rapport à l'axe principal (5) du système de microscopie électronique (3).

13. Installation optique à particules selon la revendication 12, en liaison avec la revendication 11, dans laquelle la tension amenée par le dispositif d'alimentation en tension (60) à l'électrode annulaire (59) en cours de fonctionnement de l'installation optique à particules (1) présente différentes valeurs pour différentes orientations de la surface (15) de l'objet (13) par rapport à l'axe principal (5) du système de microscopie électronique (3).

14. Installation optique à particules selon la revendication 13, dans laquelle l'électrode de protection (81) est configurée de telle sorte que pour une orientation de la surface (15) de l'objet (13) sensiblement orthogonale à l'axe principal (9) du système de traitement à faisceau d'ions (7) et un réglage correspondant de la tension amenée à l'électrode annulaire (59) en cours de fonctionnement, une distribution d'un champ électrique suivant l'axe principal du système de traitement à faisceau d'ions se crée de sorte que la relation suivante est satisfaite :

$$\left| \frac{e}{2W_{kin}} \int_0^z E_\perp(z) \cdot z \cdot dz \right| < 10 \, \mu m \ ,$$

où :

e représente la charge élémentaire,
z représente la distance à la surface (15) de l'objet (13) suivant l'axe principal (9) du système de traitement à faisceau d'ions (7),

$E_\perp(z)$ représente la composante du champ électrique, orientée perpendiculairement à l'axe principal (9) du système de traitement à faisceau d'ions (7), à un emplacement disposé suivant l'axe principal (9) à la distance z de la surface (15) de l'objet (13),

Z représente une distance suivant l'axe principal (9) du système de traitement à faisceau d'ions (7) à un emplacement disposé à l'intérieur d'une optique ionique du système de traitement à faisceau optique, et

$W_{kin}$ représente une énergie cinétique des ions du faisceau d'ions à l'emplacement de l'objet.

**Fig. 1**

Fig. 2a

Fig. 2b

Fig. 3a

Fig. 3b

Fig. 4

Fig. 5a

Fig. 5b

Fig. 6a

Fig. 6b

**IN DER BESCHREIBUNG AUFGEFÜHRTE DOKUMENTE**

**In der Beschreibung aufgeführte Patentdokumente**

- US 20050184251 A1

- US 6855938 B